# EUROPÄISCHE PATENTANMELDUNG

(11) **EP 2 784 706 A2**
(43) Veröffentlichungstag der Anmeldung: **01.10.2014**
(21) Anmeldenummer: 14172328.8
(22) Anmeldetag: 19.10.2010
(51) Int. Cl.: G06F 17/50, G03B 37/04, G06Q 30/02, G06Q 50/04

(54) **Verfahren zur Bereitstellung und Verwendung digitaler Dekordaten**

(30) Priorität: 05.02.2010 DE 102010007125
(62) Teilanmeldung aus: 10779727.6
(71) Anmelder: Fritz Egger GmbH & Co. OG, 3105 Unterradlberg (AT)
(72) Erfinder: Monhoff, Klaus, 59759 Arnsberg (DE); Müller, Stefan, 6380 St. Johann in Tirol (AT); Höglauer, Hubert, 83317 Teisendorf (DE)
(74) Vertreter: Cohausz & Florack

(57) **Zusammenfassung**

Verfahren zur Bereitstellung und Verwendung digitaler Dekordaten, umfassend:
- Erzeugen und/oder Sammeln von digitalen Dekordaten und digitalen Oberflächenstrukturdaten,
- Speichern der Dekordaten und Oberflächenstrukturdaten in einer zentralen Datenbank,
- Bereitstellen der gespeicherten Daten zur Visualisierung von Dekoren in Kombination mit Oberflächenstrukturen an vom Standort der Datenbank entfernten Orten, und
- Herstellen von mit mindestens einem Dekor versehenen Holzwerkstoffprodukten und Werbemitteln unter Verwendung der gespeicherten Daten.

## Beschreibung

Die Erfindung betrifft ein Verfahren zur Bereitstellung und Verwendung digitaler Dekordaten. Die Erfindung betrifft insbesondere einen Gesamtprozess für einen Digitaldruck von Dekoren in Verbindung mit Holzwerkstofferzeugnissen, wie zum Beispiel Fußboden-, Decken- und Wandpaneelen und/oder Möbelteilen.

Verfahren zur Herstellung von mit einem Dekor, insbesondere Holzdekor versehenen Holzwerkstoffplatten, bei denen das Dekor mittels eines digitalen Druckwerks aufgebracht wird, sind bekannt.

Der vorliegenden Erfindung liegt die Aufgabe zugrunde, ein Verfahren bzw. einen Gesamtprozess zur Bereitstellung und Verwendung digitaler Dekordaten anzugeben, mit dem sich eine Vielzahl künstlich sowie sehr natürlich anmutender Dekoroberflächen in hoher Qualität und auf effiziente Weise visualisieren und herstellen lässt.

Diese Aufgabe wird durch ein Verfahren mit den Merkmalen des Anspruchs 1 gelöst. Bevorzugte und vorteilhafte Ausgestaltungen des Verfahrens bzw. Gesamtprozesses sind in den Unteransprüchen angegeben.

Das erfindungsgemäße Verfahren umfasst folgende Schritte: Erzeugen und/oder Sammeln von digitalen Dekordaten und digitalen Oberflächenstrukturdaten,

Speichern der Dekordaten und Oberflächenstrukturdaten in einer zentralen Datenbank (Dekordatenbank), Bereitstellen der gespeicherten Daten zur Visualisierung von Dekoren in Kombination mit Oberflächenstrukturen an vom Standort der Datenbank entfernten Orten, und Herstellen von mit mindestens einem Dekor versehenen Holzwerkstofferzeugnissen und Werbemitteln unter Verwendung der gespeicherten Daten.

Eine vorteilhafte Ausgestaltung des erfindungsgemäßen Verfahrens sieht vor, dass die Dekore in Kombination mit Oberflächenstrukturen mittels eines oder mehrerer Bildprojektoren in einer räumlichen Umgebung visualisiert werden. Bei Verwendung von mehreren Bildprojektoren ist vorgesehen, dass sich die einzelnen durch die Bildprojektoren erzeugten Bilder ergänzen. Die Visualisierung von Dekoren in Kombination mit Oberflächenstrukturen erfolgt somit jeweils in einem virtuellen Raum. Die räumliche Umgebung wird hierzu vorzugsweise mit mindestens einem die Abmessungen eines Möbels aufweisenden Korpus ausgestattet. Beispielsweise entspricht der Korpus Unterschränken, Oberschränken und/oder Hochschränken einer Küchenzeile, einem Kleiderschrank, einem Bücherregal oder dergleichen. Die als Projektionsfläche dienende Oberfläche des Korpus bzw. der räumlichen Umgebung ist einfarbig gestaltet. Beispielsweise ist die zur Visualisierung der Dekore und Oberflächenstrukturen dienende Projektionsfläche des Korpus, eines angrenzenden Fußbodens und/oder einer an den Korpus angrenzenden Wand in grauer Farbe gestrichen oder mit einer grauen Stoffbahn beschichtet. Des Weiteren sind bzw. werden an dem Korpus Griffe oder andere Beschläge angebracht, die während der Visualisierung der Dekore und Oberflächenstrukturen auf dem Korpus beim Betrachter den Eindruck eines wirklichen Möbels verstärken.

Eine weitere vorteilhafte Ausgestaltung des erfindungsgemäßen Verfahrens ist dadurch gekennzeichnet, dass die Dekore in Kombination mit Oberflächenstrukturen mittels eines Bildschirms, vorzugsweise eines Tastbildschirms ("Touchscreen") visualisiert werden. Bei dem Bildschirm handelt es sich vorzugsweise um einen hochauflösenden Tastbildschirm, an dem ein Benutzer durch Berühren des Bildschirms verschiedene Dekore in Kombination mit verschiedenen Oberflächenstrukturen (Texturen) auswählen und betrachten kann. Der Benutzer hat insbesondere die Möglichkeit, aus der Vielzahl der in der zentralen Datenbank gespeicherten Dekordaten und Oberflächenstrukturendaten ein individuell zusammengestelltes Gesamtdekor auf dem Bildschirm zu erstellen.

In weiterer Ausgestaltung sieht das erfindungsgemäße Verfahren vor, dass die Dekordaten durch Scannen von Mustern existierender Dekore, Schichtstoffe und/oder Echtmaterialien gewonnen werden. Bei den Echtmaterialien handelt es sich beispielsweise um Echtholzplatten, Echtholzfurniere, Steinplatten, Fliesen, Lederfelle, etc.

Ferner sieht das erfindungsgemäße Verfahren vor, dass die Oberflächenstrukturdaten durch Scannen dreidimensionaler Oberflächenstrukturen gewonnen werden. Bei den mittels eines Scanners erfassten dreidimensionalen Oberflächenstrukturen kann es sich um künstliche oder natürliche Strukturen handeln, beispielsweise um Holz- oder Steinstrukturen, Reliefs, Fugenraster, Gitter, Netze, etc. Des Weiteren ist vorgesehen, dass Oberflächenstrukturen durch Scannen vorhandener Strukturgeberbänder oder Strukturpressbleche erfasst und gespeichert werden.

Zur digitalen Erfassung der Dekore und dreidimensionalen Oberflächenstrukturen wird vorzugsweise ein hochauflösender Scanner verwendet, der durch mehrmalige Erfassung der Oberfläche aus unterschiedlichen Richtungen insbesondere die strukturelle Ausgestaltung der Dekore bzw. Oberflächenstrukturen in hoher Qualität erfassen kann.

Darüber hinaus sieht eine bevorzugte Ausgestaltung des erfindungsgemäßen Verfahrens vor, dass als Dekordaten solche von Dekordruckereien und/oder Dekorentwicklern verwendet bzw. gesammelt werden. Auch ist in dem erfindungsgemäßen Verfahren vorgesehen, dass als Strukturdaten solche von Herstellern von Strukturgeberbändern und/oder Strukturpressblechherstellern herangezogen werden.

Sämtlich der so erzeugten und/oder gesammelten digitalen Dekordaten und digitalen Oberflächenstrukturdaten werden in einer zentralen Datenbank hinterlegt. Sammlung und Hinterlegung der Dekor- und Oberflächenstrukturdaten werden vorzugsweise von einer zentralen Dekorentwicklungsabteilung durchgeführt. Die von externen Dekordruckereien und/oder Dekorentwicklern erhaltenen Dekordaten sowie die gegebenenfalls von Herstellern von Strukturgeberbändern und/oder Pressblechherstellern erhaltenen Strukturdaten werden von der Dekorentwicklungsabteilung gegebenenfalls bearbeitet bzw. an vorgegebene Datenformate angepasst.

Insbesondere sieht das erfindungsgemäße Verfahren vor, dass die in der zentralen Datenbank gespeicherten Daten verwaltet und durch weitere erzeugte und/oder gesammelte Dekordaten und/oder Oberflächenstrukturdaten angereichert werden.

Ferner ist vorgesehen, dass den Dekordaten und Oberflächenstrukturdaten Produktinformationen zugeordnet werden, welche zusammen mit den jeweiligen Dekordaten und/oder Oberflächenstrukturdaten in der zentralen Datenbank (Dekordatenbank) gespeichert werden.

Eine weitere bevorzugte Ausgestaltung des erfindungsgemäßen Verfahrens besteht darin, dass die gespeicherten Daten über ein dezentrales Datennetzwerk, vorzugsweise das Internet Anwendern (z.B. Händlern und Verarbeitern), die sich an verschiedenen Standorten befinden, bereitgestellt werden.

Die entsprechend den in der zentralen Datenbank gespeicherten Daten hergestellten Werbemittel umfassen vorzugsweise Muster, Broschüren, Kataloge und/oder Kollektionen.

Nach einer weiteren vorteilhaften Ausgestaltung des erfindungsgemäßen Verfahrens werden die Dekore in Kombination mit Oberflächenstrukturen auf einem Korpus räumlich visualisiert, der die Abmessungen eines Originalkorpusmöbels aufweist, wobei mindestens drei aneinandergrenzende Seiten des Korpus mit elektronischem Papier, vorzugsweise mit mindestens einer aus organischen Leuchtdioden (OLED) gebildeten Folie beschichtet sind. Das elektronische Papier ist dabei vorzugsweise nach Art eines Touchscreens ausgebildet, so es zugleich als Eingabegerät verwendet werden kann.

Zur Sicherstellung einer farbgetreuen bzw. farbrichtigen Ausgabe insbesondere der Dekore bei deren Visualisierung ist ferner vorgesehen, dass mindestens ein zur Digitalisierung von Mustern existierender Dekore, Schichtstoffe, Echtmaterialien und/oder von dreidimensionalen Oberflächenstrukturen verwendeter Scanner sowie zur Visualisierung der Dekore verwendete Ausgabegeräte, insbesondere Bildschirme, Bildprojektoren und/oder Farbdrucker, kalibriert und/oder profiliert werden.

Nachfolgend wird die Erfindung anhand einer mehrere Ausführungsbeispiele darstellenden Grafik (Zeichnung) näher erläutert. Es zeigen:

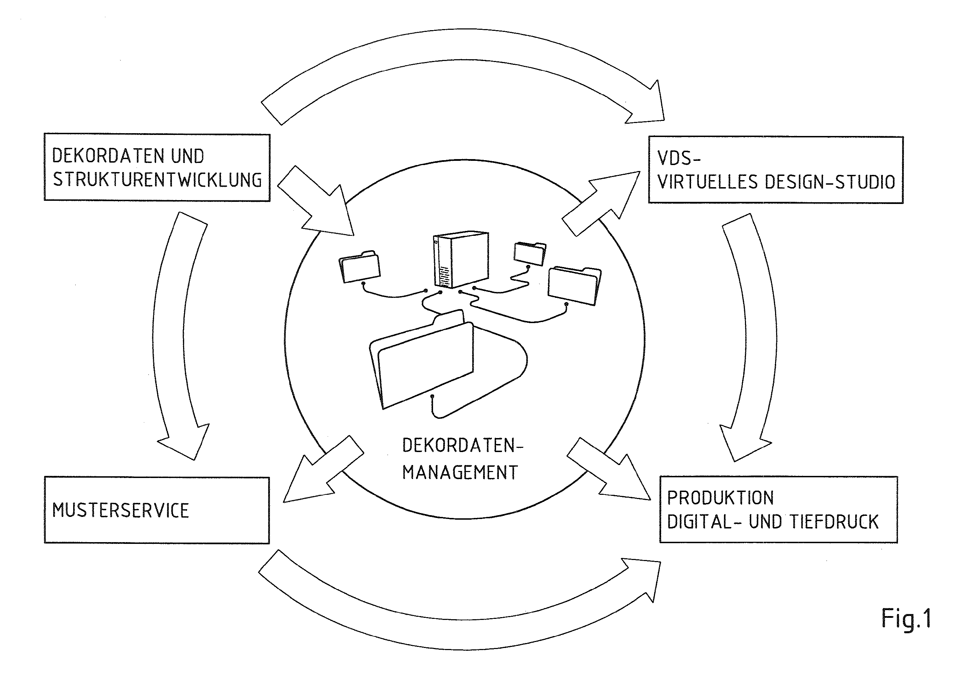

- Fig. 1: eine vereinfachte schematische Darstellung des erfindungsgemäßen Gesamtprozesses (Verfahrens); und

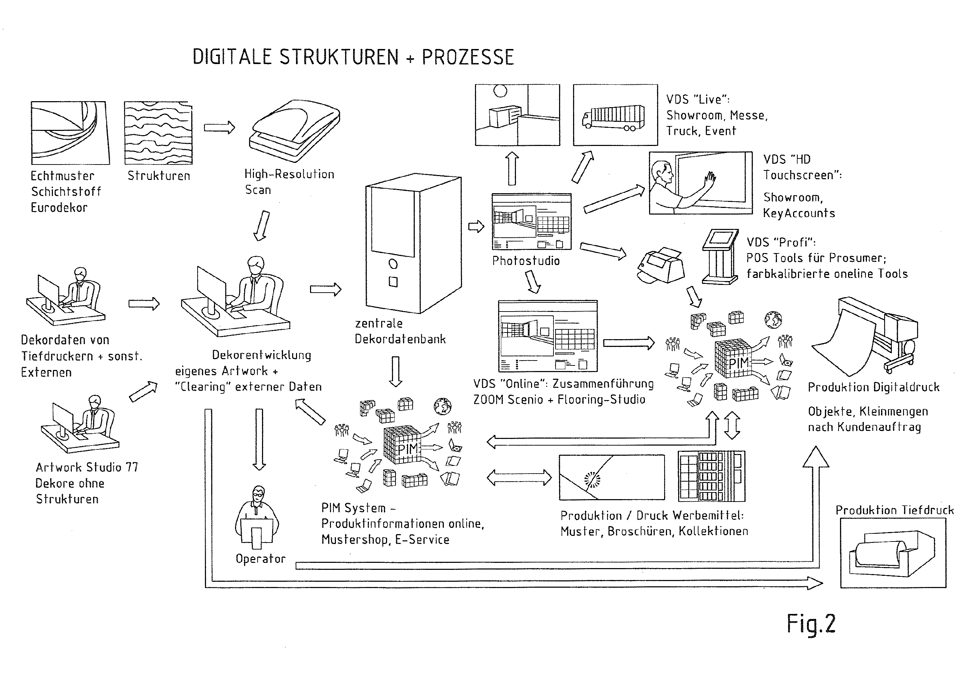

- Fig. 2: eine gegenüber Fig. 1 mehr detaillierte Darstellung des erfindungsgemäßen Gesamtprozesses (Verfahrens).

Das erfindungsgemäße Verfahren betrifft einen Prozess, der mehrere Teilprozesse umfasst. Das Verfahren basiert auf der Entwicklung/Erzeugung von Dekoren und Oberflächenstrukturen und dem Sammeln und Verwalten entsprechender Dekor- und Oberflächenstrukturdaten.

Kern des Verfahrens ist ein Dekordatenmanagement unter Verwendung einer zentralen Dekordatenbank, in der sämtliche im Rahmen des Verfahrens selbst entwickelten bzw. erzeugten sowie von Externen erhaltenen Dekor- und Oberflächenstrukturdaten hinterlegt werden. Die hinterlegten Daten stammen aus digitalen Abtastungen bei neuen Entwicklungen, aus Mustern bestehender Dekore und Strukturen, von Tiefdruckverfahren durchführenden Druckereien, Dekorentwicklern oder sonstigen externen Anbietern. Die Sammlung/Hinterlegung dieser Dekor- und Strukturdaten wird von einer Dekorentwicklungsabteilung durchgeführt.

Das digitale Abtasten von Originalmustern bzw. Vorlagen, bei denen es sich beispielsweise um bereits vorhandene Dekore und Strukturen aber auch um Neuentwicklungen handeln kann, wird mittels eines hochauflösenden Scanners durchgeführt. Die Auflösung des verwendeten Scanners liegt vorzugsweise im Bereich von 1.000 bis 3.000 dpi. Ein Originalmuster bzw. eine zu digitalisierende Vorlage wird dabei auf einen Tisch oder einen Träger gelegt. Um ein Verrutschen der Vorlage während des Scanvorgangs zu verhindern, wird die Vorlage auf dem Tisch bzw. Träger fixiert, beispielsweise indem der Tisch mit einer Ansaugplatte (Vakuumplatte) versehen wird. Eine oder zwei parallel zueinander angeordnete Lichtschienen werden sodann zusammen mit einem Scannerkopf über die Vorlage geführt bzw. der Vorlagentisch wird unterhalb der Lichtschiene(n) und dem die Aufnahmeoptik aufweisenden Scannerkopf verfahren. Synchron dazu digitalisiert der Scanner die aufgenommene Bildinformation. Die zu digitalisierende Vorlage wird dabei vorzugsweise mit unterschiedlichen Lichteinstellungen und/oder -kombinationen beleuchtet, um feinste Strukturen plastisch sichtbar zu machen. Hierzu ist die mindestens eine Lichtschiene mit steuerbaren Lichtführungselementen, z.B. Lichtblenden, versehen, welche die Einstellung unterschiedlicher Lichtkombinationen ermöglichen.

In einem Farbmanagementprozess werden die digitalen Dekor- und/oder Oberflächenstrukturdaten für unterschiedliche Ausgabemedien aufbereitet, zum Beispiel für Printmedien, farbkalibrierte Bildschirme, hochauflösende Bildprojektorpräsentationen (Beamer) sowie für die Produktion in Digitaldruck- und/oder Tiefdruckverfahren.

Aus den gesammelten digitalen Dekor- und Oberflächenstrukturdaten werden alle erforderlichen/benötigten Reproduktionen hergestellt, nämlich:
- die eigentlichen Produkte (Erzeugnisse), zum Beispiel in Kleinmengen (Kleinserie) im Digitaldruckverfahren oder in Großserie im Tiefdruckverfahren hergestellte Dekore für Holzwerkstoffe und Laminatfußböden in Kombination mit Oberflächenstrukturen (Texturen), wobei für das Tiefdruckverfahren zuvor mindestens ein entsprechender Druckzylinder und mindestens eine Strukturgebung angefertigt werden müssen;
- Bemusterungen und/oder Werbemittel:
   a) reale Muster, Broschüren, Kataloge, Kollektionen; und
   b) virtuelle Präsentationen im Internet, in Ausstellungsräumen, auf einem Messestand, insbesondere einem mobilen Messestand (Lastkraftwagen).

Durch den im Rahmen des erfindungsgemäßen Verfahrens angewandten Farbmanagementprozess wird eine farbrichtige Ausgabe (Wiedergabe) der farbigen Dekore und Oberflächenstrukturen erreicht. Hierzu wird die jeweilige Eingabevorrichtung (Scanner, Digitalkamera) sowie die jeweilige Ausgabevorrichtung (Bildschirm, Bildprojektor und/oder Drucker) kalibriert und profiliert.

Bei der Kalibrierung der jeweiligen Eingabe- oder Ausgabevorrichtung werden technische Parameter der Vorrichtung so eingestellt, dass bestimmte Grundeigenschaften vorliegen. Hierzu wird die betreffende Vorrichtung zuerst in eine vorgegebene Basiseinstellung (Werkseinstellung) zurückgesetzt, um die zuletzt vorgenommenen Einstellungen, z.B. bei einem Bildschirm eine besonders hohe Helligkeit, auf die Basiseinstellung zurückzusetzen. Anschließend werden bestimmte technische Parameter der jeweiligen Vorrichtung eingestellt, z.B. bei einem Bildschirm die Helligkeit und die Farbtemperatur.

Bei der Profilierung wird die jeweilige Eingabe- oder Ausgabevorrichtung hinsichtlich vorhandener Farbfehler vermessen. Die gemessenen Farben (Istwerte) werden dabei mit Sollwerten (Referenzfarbwerten) verglichen und die bei dem Vergleich festgestellten Abweichungen (Farbfehler) in einer Profildatei bzw. Korrekturtabelle gespeichert. Die Profildatei oder Korrekturtabelle wird dann als Korrekturprofil beim Scannen von Dekoren und Oberflächenstrukturen sowie bei der Wiedergabe der zentral gespeicherten digitalen Dekor- und Oberflächenstrukturdaten auf Ausgabevorrichtungen wie Bildschirmen, Bildprojektoren und Druckern verwendet.

Die Profilierung eines in dem erfindungsgemäßen Verfahren verwendeten Scanners wird unter Verwendung einer genormten Vorlage mit Referenzfarbwerten, einer Profilierungssoftware und einer Referenzfarbtabelle durchgeführt. Dabei wird die Vorlage, die eine Vielzahl von Referenzfarbwerte darstellenden Farbfeldern aufweist, mit dem Scanner gescannt. Aus dem Vergleich der gemessenen Farben der Vorlage mit der Referenzfarbtabelle berechnet die Profilierungssoftware ein Korrekturprofil (auch ICC-Profil genannt) für den Scanner, das bei nachfolgenden Aufnahmen (Scans) von Dekoren und/oder Oberflächenstrukturen automatisch zur Korrektur verwendet wird.

Die Profilierung eines in dem erfindungsgemäßen Verfahren verwendeten Bildschirms, insbesondere Touchscreens, wird mittels eines Kolorimeters und einer Profilierungssoftware durchgeführt. Das Kolorimeter wird über ein geeignetes Kabel an dem Rechner (Computer) angeschlossen, der den Bildschirm mittels einer Grafikkarte steuert und auf den zuvor auch die Profilierungssoftware geladen wurde. Das Kolorimeter kann die Farben von selbst leuchtenden Objekten messen. Die Profilierungssoftware steuert die Grafikkarte so, dass auf dem Bildschirm verschiedene Farbtöne dargestellt werden. Das Kolorimeter misst den jeweiligen Farbton und die Profilierungssoftware vergleicht den Messwert (Istwert) mit dem Sollwert. Aus dem Vergleich der Messwerte mit den Sollwerten der verschiedenen Farbtöne wird so ein gerätespezifisches Farbprofil (ICC-Profil) erstellt, das in dem Rechner (Computer) abgelegt und als Korrekturprofil für den Bildschirm unter Einbeziehung der zugehörigen Grafikkarte verwendet wird.

Die Profilierung eines in dem erfindungsgemäßen Verfahren verwendeten Farbdruckers (Tintenstrahldruckers oder Laserfarbdruckers) wird ebenfalls mittels einer Profilierungssoftware und eines geeigneten Messgerätes durchgeführt, wobei das Messgerät an dem den Farbdrucker steuernden Rechner angeschlossen wird. Unter Verwendung der Profilierungssoftware wird auf dem Farbdrucker eine Vielzahl von Testfarben in Form eines sogenannten Test-Charts ausgedruckt. Die Testfarben werden als Farbfelder auf das Test-Chart gedruckt. Jedes einzelne Farbfeld wird mittels des Messgerätes, bei dem es sich vorzugsweise um ein Spektralfotometer handelt, gemessen. Die Messwerte (Istwerte) werden wiederum mit Referenzfarbwerten (Sollwerten) verglichen, wobei die Profilierungssoftware aus dem Vergleich der Messwerte mit den Referenzfarbwerten ein Druckerprofil (ICC-Profil) erstellt, das in dem Rechner gespeichert wird. Bei der Druckerprofilierung wird auch berücksichtigt, dass die Druckqualität von der verwendeten Druckerpapiersorte sowie der Tinte bzw. Farbe abhängt. Um eine optimale Druckqualität zu erzielen, wird daher für jede Papier-Tinten-Kombination ein eigenes Druckerprofil erstellt. Das in Abhängigkeit der jeweiligen Papier-Tinten-Kombination ausgewählte Druckerprofil wird dann als Korrekturprofil für den Drucker verwendet, indem die in den zu druckenden Dekordaten und/oder Oberflächenstrukturdaten enthaltenen Farbwerte anhand des Druckerprofils vom Druckertreiber automatisch korrigiert werden.

Die in dem erfindungsgemäßen Verfahren verwendeten Eingabevorrichtungen (z.B. Scanner) und Ausgabevorrichtungen (Bildschirme, Bildprojektoren und/oder Drucker) werden mit Hilfe einer gemeinsamen Farbreferenz profiliert, beispielsweise mit Hilfe eines genormten, geräteunabhängigen Farbmodells.

Vorzugsweise werden alle in dem erfindungsgemäßen Verfahren verwendeten Eingabe- und Ausgabevorrichtungen in der vorstehend beschriebenen Weise kalibriert und profiliert.

Für die virtuelle Präsentation im Internet wird vorzugsweise ein Visualisierungswerkzeug verwendet, mit dem sich ein Nutzer virtuell in einen Raum begeben und ausprobieren kann, wie verschiedene Dekore in Kombination mit unterschiedlichen Boden- und/oder Wandbelägen und/oder Wandfarben wirken. So kann der Nutzer einen fotorealistischen Eindruck von der geplanten späteren Wohn- oder Arbeitsumgebung erhalten. Diese Art der Präsentation bringt dem Nutzer Sicherheit und erleichtert ihm die Auswahl eines der verschiedenen Dekore. Des Weiteren umfasst diese Präsentation die Möglichkeit, dass der Nutzer aus einer Vielzahl verschiedener Wohnraum- oder Einrichtungssituationen eine bestimmte Situation auswählen kann und dann ausprobieren kann, wie verschiedene Dekore bzw. Laminatfußböden in Kombination mit unterschiedlichen Wandfarben sowie Möbeln wirken. Diese virtuelle Präsentation kann auch als internetbasiertes virtuelles Design-Studio (VDS) bezeichnet werden.

Alternativ oder zusätzlich umfasst der Begriff "Virtuelles Design-Studio" (VDS) im Kontext der vorliegenden Erfindung auch Bemusterungen bzw. Visualisierungen mittels hochauflösender Tastbildschirme (so genannte "HD Touchscreens") in Verkaufsräumen (Ausstellungen) sowie auf Messeständen. Bei den im Rahmen des erfindungsgemäßen Verfahrens verwendeten Tastbildschirmen handelt es sich vorzugsweise um solche, die dem Nutzer eine elektronisch erzeugte, taktile Wahrnehmbarkeit einer dargestellten Oberflächenstruktur bieten.

Der verwendete Touchscreen weist verschiedene Funktionalitäten zur hochauflösenden Darstellung von Dekoren in Kombination mit Oberflächenstrukturen (Texturen) auf. An dem Touchscreen oder einer Prozessoreinrichtung (Computer) zur Steuerung des Touchscreens ist vorzugsweise ein Farbdrucker oder Farbplotter angeschlossen, mittels dem sich der Nutzer eine von ihm ausgewählte oder individuelle zusammengestellte Dekor-Oberflächenstruktur-Kombination ausdrucken lassen kann.

Des Weiteren umfasst die Visualisierung von Dekoren und Oberflächenstrukturen im Rahmen des erfindungsgemäßen Verfahrens die Verwendung eines oder mehrerer Bildprojektoren ("Beamer"), mittels derer die Dekore und Strukturen in einer räumlichen Umgebung visualisiert werden. Bei Verwendung mehrerer Bildprojektoren ist vorgesehen, dass sich die einzelnen durch die Bildprojektoren erzeugten Bilder ergänzen. Die Bildprojektoren ("Multi-Beamer") werden dabei synchron oder zeitversetzt angesteuert. Die Projektion der Dekore und Strukturen erfolgt vorzugsweise auf einem oder mehreren Körpern, die in ihren Abmessungen Küchen- oder Wohnraummöbeln entsprechen und mit einer einheitlichen Farbe, beispielsweise einem Grauton versehen sind. Der (graue) Körper ähnelt beispielsweise einer aus Unterschränken und Hochschränken gebildeten Küchenzeile oder einer Kommode mit angrenzendem Bücherregal. Mittels des Bildprojektors bzw. der Bildprojektoren werden neben den Dekoren und Oberflächenstrukturen zudem auch Elektrogeräte, wie zum Beispiel ein Backofen, oder Bücher und/oder Wohnaccessoires auf den mindestens einen Körper projiziert. Dem Betrachter wird durch diese Art der Präsentation ein besonders wirklichkeitsnaher, dreidimensionaler Eindruck vermittelt, wobei unterschiedliche Dekore in Kombination mit unterschiedlichen Oberflächenstrukturen gleichzeitig visualisiert werden können. So können beispielsweise bei einer Küche unterschiedliche Schranktürfronten in Kombination mit unterschiedlichen Arbeitsplatten visualisiert werden. Sämtliche digital entwickelten Dekordaten können dabei mit ebenfalls nur digital vorliegenden Texturdaten (Oberflächenstrukturen) kombiniert und in ihrer dreidimensionalen Wirkung visualisiert werden, wobei sich Licht- und Glanzeffekte je nach Blickwinkel des Betrachters verändern.

Die Visualisierung mittels eines einzelnen Bildprojektors oder mehrerer gemeinsam betriebener Bildprojektoren wird im Rahmen des erfindungsgemäßen Verfahrens vorzugsweise in Verkaufsräumen und auf Messen durchgeführt. Insbesondere ist eine solche Präsentation unter Verwendung eines mobilen Trailers bzw. Lastkraftwagens ("Truck") vorgesehen.

Des Weiteren umfasst die Visualisierung von Dekoren und Oberflächenstrukturen im Rahmen des erfindungsgemäßen Verfahrens die Verwendung einer Auftragsabwicklungseinrichtung, die einen Computer, einen Bildschirm sowie einen Farbdrucker oder -plotter umfasst. Diese Einrichtung ermöglicht einen individualisierten Dekordigitaldruck und wird vorzugsweise professionellen Anwendern (Händlern und Verarbeitern) zur Verfügung gestellt ("VDS Profi"). Ziel dabei ist, dass die Qualität der visualisierten und/oder gedruckten bzw. geplotteten Dekore von der Bestellung bis zur Herstellung durchgängig farbverbindlich ist und damit ein bezüglich Kosten und Durchlaufzeiten hoch effizienter Auftragsabwicklungsprozess geschaffen wird. Die Auftragsabwicklungseinrichtung ermöglicht eine automatische Auftragsabwicklung hinsichtlich der Produktion von mit Dekoren und Oberflächenstrukturen versehenen Mustern und/oder Holzwerkstofferzeugnissen.

Für einzelne Objekte (Bauvorhaben) sowie Kleinmengen werden das Dekor und die Oberflächenstruktur des jeweiligen Holzwerkstofferzeugnisses vorzugsweise unter Verwendung eines Digitaldruckverfahrens hergestellt.

Bei der Herstellung in Großserie werden das Dekor und die Oberflächenstruktur des jeweiligen Holzwerkstofferzeugnisses dagegen unter Verwendung eines Tiefdruckverfahrens hergestellt. Dies setzt die Herstellung mindestens eines Druckzylinders und mindestens einer strukturgebenden Walze oder dergleichen auf Basis der gespeicherten Dekordaten bzw. Oberflächenstrukturdaten voraus.

Das zentrale Dekordatenmanagement ist mit einem Produktinformationsmanagement-System verknüpft. Unter Produktinformationsmanagement (PIM) wird die Bereitstellung von Produktinformationen für den Einsatz in verschiedenen Ausgabemedien bzw. Vertriebskanälen sowie für unterschiedliche Standorte verstanden. Die Verwaltung, Pflege und Modifikation der Produktinformationen erfolgt in einem zentralen System, vorzugsweise in der zentralen Dekordatenbank oder in Verbindung mit derselben. Jeder Standort bzw. Kanal in dem erfindungsgemäßen Gesamtprozess kann somit ohne großen Ressourcenaufwand mit übereinstimmenden Produktinformationen über ein Datenübertragungsnetz versorgt werden. Das PIM-System ermöglicht eine effiziente Datenübernahme, Datenverwaltung, Datenanreicherung und Datenausgabe. Es konsolidiert alle Produktinformationen in einer Datenbank. Die Produktinformationen können aus der zentralen Datenhaltung für die Erstellung von Mustern (Musterservice), Broschüren, Katalogen und/oder Kollektionen herangezogen werden.

Die dezentral existierenden virtuellen Design-Studios werden zentral verwaltet und automatisiert mit Updates versehen.

Eine weitere vorteilhafte Ausgestaltung des erfindungsgemäßen Verfahrens besteht in einem Bildservice, der es einem Nutzer eines der virtuellen Design-Studios ermöglicht, eigene Raum- und/oder Möbelbilder in ein virtuelles Design-Studio-Programm zu laden bzw. einzufügen. Hierzu markiert der Nutzer in einem digitalen Foto eine gewünschte Raum- und/oder Möbelfläche und notiert in einem zugehörigen Textfeld oder alphanumerischen Feld Referenzmaße der fotografierten Raum- und/oder Möbelfläche. Als Referenzmaße werden beispielsweise die Höhe und Breite einer Wand des fotografierten Raums oder die Höhe und Breite eines fotografierten Möbels notiert. Hierdurch wird eine maßstabgetreue sowie hinsichtlich der Perspektive richtige Darstellung von in der zentralen Datenbank gespeicherten Dekoren und Oberflächenstrukturen bei deren späterer Visualisierung unter Verwendung des vom Nutzer fotografierten Raum- und/oder Möbelbildes sichergestellt. Das markierte Raum- und/oder Möbelbild wird an den Bildservice zur Bearbeitung gesendet, wo es in ein neutrales Raum- bzw. Möbelbild aufbereitet (umgewandelt) wird. Das so aufbereitete neutrale Raum- bzw. Möbelbild wird in einer Datei gespeichert, die dem Einsender bzw. Nutzer des Raum und/oder Möbelbildes zugeordnet wird. Das aufbereitete neutrale Raum- bzw. Möbelbild steht dann dem Nutzer des erfindungsgemäßen virtuellen Design-Studios zur individuellen Visualisierung von Dekoren und Oberflächenstrukturen zur Verfügung.

Eine vorteilhafte Weiterbildung des erfindungsgemäßen Verfahrens besteht ferner darin, dass ein derartiges virtuelles Design-Studio-Programm auf mit einer Digitalkamera ausgestatteten Mobiltelefonen, insbesondere sogenannten smartphones zur Verfügung gestellt wird. Der Nutzer kann dann mit seinem Mobiltelefon bzw. smartphone ein Bild einer realen Raumsituation aufnehmen, dem aufgenommenen Bild Referenzmaße zuordnen und einen oder mehrere bestimmte Bildbereiche, z.B. einen Fußboden, eine Raumwand und/oder Möbel auswählen, die er mit einem oder mehreren der in der zentralen Datenbank gespeicherten Dekore und Oberflächenstrukturen versehen und auf dem Bildschirm (Display) seines Mobiltelefons bzw. smartphones betrachten möchte. Durch die Zuordnung von Referenzmaßen bzw. eines sogenannten Markers wird sichergestellt, dass die Dekore und Oberflächenstrukturen maßstabgetreu und in der richtigen Perspektive in dem aufgenommenen Bild visualisiert werden.

Der erfindungsgemäße Gesamtprozess stellt somit praktisch einen geschlossenen Kreislauf dar. Es handelt sich um einen vernetzten Kreislauf von der Dekorentwicklung über die Visualisierung bis hin zur Produktion. Durch diesen ganzheitlichen und integrierten Prozess lässt sich die Geschwindigkeit der Realisierung einer Idee erhöhen und auch die Servicequalität steigern.

Durch die Möglichkeiten in der Visualisierung mit dem Virtuellen Design-Studio können Kunden, Händler sowie sonstige Nutzer eine Vorselektion vornehmen, auf deren Basis dann eine fundierte Dekorentscheidung getroffen werden kann.

Die Vorteile des erfindungsgemäßen digitalen Prozesses lassen sich wie folgt zusammenfassen:
- Der Prozess von der Idee des Nutzers bis zur Bemusterung und Umsetzung in konkrete Produkte, beispielsweise Fußbodenpanelle oder Möbelbauteile, wird effizienter und schneller.
- Die Kosten im Dekorentscheidungsprozess und im Vertrieb werden reduziert.
- Risiken bei Produktneueinführungen werden minimiert.
- Dekore und Raumbilder stehen hoch aufgelöst und druckbar für Anwendungen in Vertrieb und Marketing zur Verfügung.
- Die Dekordaten sind farbgetreu abgestimmt zwischen Originalmustern und Visualisierungssystemen.

## Patentansprüche

1. Verfahren zur Bereitstellung und Verwendung digitaler Dekordaten, umfassend:
- Kalibrieren und Profilieren einer von einem Scanner gebildeten Eingabevorrichtung, einer von einem Bildschirm gebildeten Ausgabevorrichtung und einer von einem Drucker gebildeten Ausgabevorrichtung, wobei die Eingabevorrichtung und Ausgabevorrichtungen mit Hilfe einer gemeinsamen Farbreferenz profiliert werden,
- Erzeugen von digitalen Dekordaten und digitalen Oberflächenstrukturdaten durch digitale Erfassung von Mustern existierender Dekore, Schichtstoffe und/oder Echtmaterialien und dreidimensionaler Oberflächenstrukturen mittels des Scanners, wobei die Auflösung des Scanners im Bereich von 1000 bis 3000 dpi liegt und wobei die Oberfläche aus unterschiedlichen Richtungen mehrmals erfasst wird,
- Speichern der Dekordaten und Oberflächenstrukturdaten in einer zentralen Datenbank,
- Bereitstellen der gespeicherten Daten zur Visualisierung von Dekoren in Kombination mit Oberflächenstrukturen an vom Standort der Datenbank entfernten Orten, und
- Herstellen von mit mindestens einem Dekor versehenen Holzwerkstofferzeugnissen und Werbemitteln unter Verwendung der gespeicherten Daten.

2. Verfahren nach Anspruch 1, **dadurch gekennzeichnet, dass** beim Erzeugen der digitalen Dekordaten und Oberflächenstrukturdaten die zu digitalisierende Vorlage für die digitalen Dekordaten oder Oberflächenstrukturdaten mit unterschiedlichen Lichteinstellungen und/oder -kombinationen beleuchtet wird.

3. Verfahren nach Anspruch 2, **dadurch gekennzeichnet, dass** mindestens eine Lichtschiene des Scanners mit steuerbaren Lichtführungselementen, insbesondere Lichtblenden, versehen ist, welche die Einstellung unterschiedlicher Lichtkombinationen ermöglichen.

4. Verfahren nach einem der Ansprüche 1 bis 3, **dadurch gekennzeichnet, dass** beim Profilieren des Druckers für jede Papier-Tinten-Kombination ein eigenes Druckerprofil erstellt wird, indem als Drucker ein Farbdrucker verwendet wird, unter Verwendung einer Profilierungssoftware auf dem Farbdrucker eine Vielzahl von Testfarben in Form eines Test-Charts ausgedruckt wird, wobei die Testfarben als Farbfelder auf das Test-Chart gedruckt werden, jedes einzelne Farbfeld mittels eines an einem den Farbdrucker steuernden Rechner angeschlossenen Messgeräts, insbesondere eines Spektralfotometers, gemessen wird, die Messwerte mit Referenzfarbwerten verglichen werden und die Profilierungssoftware aus dem Vergleich der Messwerte mit den Referenzfarbwerten das Druckerprofil erstellt, das in dem Rechner gespeichert wird.

5. Verfahren nach einem der Ansprüche 1 bis 4, **dadurch gekennzeichnet, dass** die Dekore in Kombination mit Oberflächenstrukturen mittels eines oder mehrerer Bildprojektoren in einer räumlichen Umgebung visualisiert werden, wobei bei Verwendung mehrerer Bildprojektoren sich die einzelnen durch die Bildprojektoren erzeugten Bilder ergänzen.

6. Verfahren nach einem der Ansprüche 1 bis 5, **dadurch gekennzeichnet, dass** die Dekore in Kombination mit Oberflächenstrukturen mittels eines Bildschirms, vorzugsweise eines Tastbildschirms visualisiert werden.

7. Verfahren nach einem der Ansprüche 1 bis 4, **dadurch gekennzeichnet, dass** die Dekore in Kombination mit Oberflächenstrukturen mittels mindestens eines Bildprojektors auf einem echten, neutralen Korpus räumlich visualisiert werden, wobei der Korpus die Abmessungen eines Originalkorpusmöbels aufweist.

8. Verfahren nach einem der Ansprüche 1 bis 4, **dadurch gekennzeichnet, dass** die Dekore in Kombination mit Oberflächenstrukturen auf einem echten Korpus räumlich visualisiert werden, der die Abmessungen eines Originalkorpusmöbels aufweist, wobei mindestens drei aneinandergrenzende Seiten des Korpus mit elektronischem Papier, vorzugsweise mit mindestens einer aus organischen Leuchtdioden gebildeten Folie beschichtet sind.

9. Verfahren nach einem der Ansprüche 1 bis 8, **dadurch gekennzeichnet, dass** die in der zentralen Datenbank gespeicherten Daten verwaltet und durch weitere erzeugte und/oder gesammelte Dekordaten und/oder Oberflächenstruktur-daten angereichert werden.

10. Verfahren nach einem der Ansprüche 1 bis 9, **dadurch gekennzeichnet, dass** den Dekordaten und Oberflächenstrukturdaten Produktinformationen zugeordnet werden, welche zusammen mit den jeweiligen Dekordaten und/oder Oberflächenstrukturdaten in der zentralen Datenbank gespeichert werden.

11. Verfahren nach einem der Ansprüche 1 bis 10, **dadurch gekennzeichnet, dass** die gespeicherten Daten über ein dezentrales Datennetzwerk, vorzugsweise das Internet Anwendern, die sich an verschiedenen Orten befinden, bereitgestellt werden.

12. Verfahren nach einem der Ansprüche 1 bis 11, **dadurch gekennzeichnet, dass** die entsprechend den in der zentralen Datenbank gespeicherten Daten hergestellten Werbemittel Muster, Broschüren und/oder Kollektionen umfassen.

13. Verfahren nach einem der Ansprüche 1 bis 12, **dadurch gekennzeichnet, dass** das Dekor und die Oberflächenstruktur des jeweiligen Holzwerkstofferzeugnisses unter Verwendung eines Digitaldruckverfahrens hergestellt werden.

14. Verfahren nach einem der Ansprüche 1 bis 13, **dadurch gekennzeichnet, dass** das Dekor und die Oberflächenstruktur des jeweiligen Holzwerkstofferzeugnisses unter Verwendung eines Tiefdruckverfahrens hergestellt werden, wobei zuvor mindestens ein Druckzylinder und mindestens eine strukturgebende Walze auf Basis der gespeicherten Daten hergestellt werden.

15. Verfahren nach einem der Ansprüche 1 bis 14, **gekennzeichnet durch** einen Bildservice, der es einem Nutzer eines virtuellen Design-Studios ermöglicht, eigene Raum- und/oder Möbelbilder in ein virtuelles Design-Studio-Programm zu laden, wobei der Nutzer in einem digitalen Foto eine bestimmte Raum- und/oder Möbelfläche markiert und Referenzmaße der fotografierten Raum- und/oder Möbelfläche notiert, wobei das markierte Raum- und/oder Möbelbild an den Bildservice zur Bearbeitung gesendet wird, wo es in ein neutrales Raum- bzw. Möbelbild aufbereitet wird, und wobei das aufbereitete neutrale Raum- und/oder Möbelbild dem Nutzer des virtuellen Design-Studios zur individuellen Visualisierung von Dekoren und Oberflächenstrukturen zur Verfügung gestellt wird.

16. Verfahren nach Anspruch 15, **dadurch gekennzeichnet, dass** das virtuelle Design-Studio-Programm auf mit einer Digitalkamera ausgestatteten Mobiltelefonen, insbesondere auf smartphones zur Verfügung gestellt wird.
